# EUROPÄISCHE PATENTSCHRIFT

(11) **EP 0 549 611 B1**
(45) Veröffentlichungstag und Bekanntmachung des Hinweises auf die Patenterteilung: **15.06.1994**
(21) Anmeldenummer: 91915129.0
(22) Anmeldetag: 03.09.1991
(51) Int. Cl.: G11C 11/409

(54) **DYNAMISCHER HALBLEITERSPEICHER MIT LESEVERSTÄRKER-ANSTEUERSCHALTUNG ZUR ERZIELUNG KURZER ZUGRIFFSZEITEN BEI NIEDRIGEM GESAMTSPITZENSTROM**
DYNAMIC SEMICONDUCTOR STORE WITH READ AMPLIFIER TUNING CIRCUIT TO OBTAIN SHORT ACCESS TIMES AT A LOW TOTAL PEAK CURRENT
MEMOIRE DYNAMIQUE A SEMI-CONDUCTEURS AVEC CIRCUIT DE COMMANDE ET D'AMPLIFICATION DE LECTURE POUR OBTENIR DES TEMPS D'ACCES COURTS AVEC UN FAIBLE COURANT DE CRETE TOTAL

(30) Priorität: 20.09.1990 DE 4029847
(43) Veröffentlichungstag der Anmeldung: 07.07.1993
(73) Patentinhaber: SIEMENS AKTIENGESELLSCHAFT, 80333 München (DE)
(72) Erfinder: RAAB, Wolfgang, D-8000 München 90 (DE); GEIB, Heribert, D-8018 Grafing (DE)
(86) Internationale Anmeldenummer: DE9100697
(87) Internationale Veröffentlichungsnummer: WO9205558

(56) Entgegenhaltungen:
- EP-A- 0 350 860
- US-A- 4 780 850
- US-A- 4 796 234
- IEEE JOURNAL OF SOLID STATE CIRCUITS, vol. 25, no. 1, February 1990, New York, US, pages 18-22; J.I. OKAMURA et al.: "Decoded-source sense amplifier for high-density DRAM's"
- IEEE JOURNAL OF SOLID STATE CIRCUITS, vol. SC-22, no. 5, October 1987, New York, US, pages 651-656; K. KIMURA: "A 65-ns 4-Mbit CMOS DRAM with a twisted driveline sense amplifier", see page 652, column 2, line 10 - page 653, column 1, line 23; figures 3,4,5

## Beschreibung

Die Erfindung betrifft einen dynamischen Halbleiterspeicher.

Ein dynamischer Halbleiterspeicher, bei dem alle Leseverstärker jeweils über einen als Widerstand geschalteten Transistor mit einer gemeinsamen SANN-Leitung verbunden sind, die einen Leitungswiderstand besitzt und über einen einzigen gemeinsamen Treibertransistor (globaler SAN-Treiber) mit Bezugspotential verbindbar ist, und bei dem ein SAN-Eingang eines jeweiligen Leseverstärkers über einen jeweiligen weiteren Transistor, der über ein Bitleitungs-Auswahlsignal aus einem Column-Dekoder ansteuerbar ist, mit Bezugspotential verbindbar ist, ist aus der Veröffentlichung mit dem Titel "Decoded-Source Sense Amplifier For High-Density DRAM's" von Okamura et al. (Toshiba) aus dem Digest of Technical Papers zum 1989 Symposium on VLSI Circuits (Seite 103 bis 104) bekannt. Damit die Leseverstärker aufgrund des Leitungswiderstandes nicht je nach geometrischer Entfernung zum gemeinsamen Treibertransistor wesentlich unterschiedlich angesteuert werden und eine gewisse gegenseitige Entkopplung der SAN-Eingänge der Leseverstärker erfolgt, sind die als Widerstände geschaltete Transistoren vorgesehen. Hierbei wird nur ein gemeinsamer Treibertransistor (globaler SAN-Treiber) und nicht, wie bei der Erfindung, mehrfach vorhandene lokale SAN-Treiber, aber dafür pro Leseverstärker jeweils ein als Widerstand geschalteter Transistor und ein durch den Column-Dekoder angesteuerter Transistor benötigt.

Aus einer weiteren Veröffentlichung von Okamura et al (IEEE Journal of Solid-State Circuits, Bd. 25, Nr. 1, Febr. 1990, Seiten 18-22) ist zusätzlich bekannt, beispielsweise jeweils vier Leseverstärker über einen als Widerstand geschalteten Transistor mit einer gemeinsamen SANN-Leitung zu verbinden und die SAN-Eingänge dieser Leseverstärker über nur einen weiteren Transistor, der durch den Column-Dekoder ansteuerbar ist, mit Bezugspotential zu verbinden, um Chipfläche zu sparen. Dies hat jedoch beispielsweise den Nachteil, daß nur eine teilweise Dekodierung (partial decoding) möglich ist.

Aus dem IEEE Journal of Solid-State Circuits, Bd. Sc-22, Nr. 5, Oktober 1987, Seite 651 bis 656 ist ein Halbleiterspeicher bekannt, bei dem pro Wortleitungsblock jeweils ein für alle Leseverstärker gemeinsamer (globaler) mehrphasiger SAN-Treiber mit einem Ende einer gemeinsamen SANN-Leitung und zusätzlich ein Treibertransistor mit dem anderen Ende der SANN-Leitung verbunden ist, wobei der Treibertransistor in seiner Funktion jedoch nicht abhängig von Bitleitungs-Auswahlsignalen ist und somit auf alle Leseverstärker eines Wortleitungsblocks gleichzeitig wirkt.

Der Erfindung liegt die Aufgabe zugrunde, einen dynamischen Halbleiterspeicher anzugeben, der bei minimalen Chipflächenbedarf und niedrigem Gesamtspitzenstrom kurze Zugriffszeiten ermöglicht. Diese Aufgabe wird erfindungsgemäß durch die im Patentanspruch 1 angegebenen Merkmale gelöst.

Der mit der Erfindung erzielbare Vorteil liegt insbesondere darin, daß bei dem nach der Erfindung ausgebildeten dynamischen Halbleiterspeicher, gegenüber des zitierten dynamischen Halbleiterspeichers von Toshiba, aufgrund einer blockweise vorhandenen Beschleunigungsschaltung zur Verkürzung der Bewertungszeit, wesentlich weniger Platz benötigt wird.

Patentanspruch 2 bis 12 sind auf bevorzugte Ausbildungen des dynamischen Halbleiterspeichers gerichtet.

Die Erfindung wird nachfolgend anhand der Zeichnung näher erläutert. Dabei zeigt
- Figur 1: einen dynamischen Halbleiterspeicher mit aus Leseverstärkern bestehenden Leseverstärkerblöcken und lokalen SAN-Treibern,
- Figur 2: detaillierte Schaltung eines Leseverstärkers nach Figur 1 angekoppelt an eine Speicherzelle,
- Figur 3: eine detallierte Schaltung eines SAN-Treibers,
- Figur 4: einen lokalen SAN-Treiber zusammen mit einer durch einen Column-Dekoder angesteuerten Beschleunigungsschaltung, bei einem erfindungsgemäßen Halbleiterspeicher, sofern für jeden Wortleitungsblock eigene Column-Dekoder vorgesehen sind,
- Figur 5: einen lokalen SAN-Treiber zusammen mit einer durch einen übergeordneten Column-Dekoder und einen Row-Dekoder angesteuerten Beschleunigungsschaltung, bei einem erfindungsgemäßen Halbleiterspeicher,
- Figur 6: einen lokalen SAN-Treiber zusammen mit einer durch einen übergeordneten Column-Dekoder angesteuerten Beschleunigungsschaltung, bei einem erfindungsgemäßen Halbleiterspeicher, für den Fall, daß die Beschleunigungsschaltung aus einem Treibertransistor und einem Auswahltransistor besteht und übergeordnete Column-Dekoder vorhanden sind,
- Figur 7: eine Schaltung zur Ansteuerung einer Beschleunigungsschaltung mit einem adressierbaren Auswahldekoder und einer Zusatzschaltung in Form einer ODER-Schaltung, bei einem erfindungsgemäßen Halbleiterspeicher,
- Figur 7a: eine Darstellung mit Schaltungsalternativen zu Figur 7 und
- Figur 8: ein Spannungszeitdiagramm zur Darstellung der Wirkung der Beschleunigungsschaltung eines erfindungsgemäßen Halbleiterspeichers.

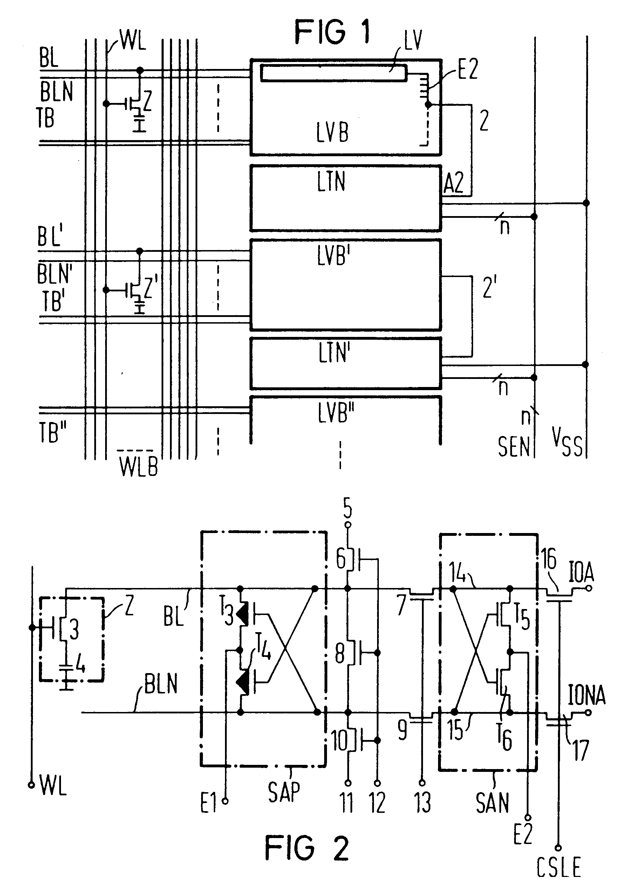

Figur 1 zeigt einen Ausschnitt eines dynamischen Halbleiterspeichers mit einer Vielzahl von Wortleitungen WL, die zu Wortleitungsblöcken WLB zusammengefaßt sind und aus einer Vielzahl von Bitleitungspaaren BL und BLN bzw. BL′ und BLN′, die zu Bitleitungsblöcken TB bzw. TB′ gruppiert sind. Im Bitleitungsblock TB ist beispielhaft eine Speicherzelle Z mit einer Wortleitung WL und einer Bitleitung BL verdrahtet, wobei der Gateanschluß des Transistors der Speicherzelle Z mit der Wortleitung WL, der Drainanschluß mit der Bitleitung BL und der Sourceanschluß über einen Zellenkondensator mit Bezugspotential verbunden ist. Ein Leseverstärkerblock LVB besteht aus einer Vielzahl vor Leseverstärkern LV, die mit Bitleitungspaaren BL, BLN verbunden sind und SAN-Eingänge E2 aufweisen. Die SAN-Eingänge E2 sind über eine lokale SANN-Leitung 2 mit einem Ausgang A2 eines lokalen SAN-Treibers LTN verbunden. Dieser lokale SAN-Treiber LTN ist seinerseits mit n Ansteuerleitungen SEN und einer Bezugsspannungsleitung V_{SS} verbunden. In analoger Weise gilt dies für weitere Bitleitungsblöcke TB′, TB˝ usw. Ein weiterer dargestellter Bitleitungsblock TB′ besitzt so zum Beispiel ein Bitleitungspaar BL′ und BLN′, Speicherzellen Z′ , einen Leseverstärkerblock LVB′, eine lokale SANN-Leitung 2′ und einen lokalen SAN-Treiber LTN′. Für den Bitlleitungsblock TB˝ ist hier nur ein Leseverstärkerblock LVB˝ angedeutet.

Die durch die Bitleitung BL und die Wortleitung WL adressierte Speicherzelle Z wird durch den Leseverstärker LV gelesen und bewertet. Zur sicheren und trotzdem schnellen Bewertung ist das Konzept mit lokalen SAN-Treibern LTN, die eine optimierte Ansteuerfunktion besitzen, von besonderem Vorteil. Ein lokaler SAN-Treiber LTN treibt hierbei einen Leseverstärkerblock mit beispielsweise 64 Leseverstärkern. Die n Ansteuerleitungen SEN sind zur n-phasigen Ansteuerung des SAN-Treibers LTN vorhanden.

In Figur 2 ist die Schaltung eines üblichen Leseverstärkers mit angekoppelter Speicherzelle Z dargestellt. Der Leseverstärker besteht hierbei im wesentlichen aus einem n-Kanal-Teil SAN und einem p-Kanal-Teil SAP. Der p-Kanal-Teil SAP ist direkt mit dem Bitleitungspaar BL und BLN verbunden und besteht aus zwei p-Kanal-Transistoren T3 und T4. Der Drainanschluß von T3 ist mit der Bitleitung BL, der Sourceanschluß von T3 ist mit dem Drainanschluß von T4 und der Gateanschluß von T3 ist mit der Bitleitung BLN verbunden. Der SAP-Eingang E1 ist mit dem Drainanschluß des Transistors T4, der Sourceanschluß ist mit der Bitleitung BLN und das Gate des Transistors T4 ist mit der Bitleitung BL verbunden. Der n-kanal-Teil SAN ist in ähnlicher Weise kreuzgekoppelt wie der p-Kanal-Teil SAP und besitzt die beiden n-Kanal-Transistoren T5 und T6. Der Drainanschluß des Transistors T5 ist dabei mit dem Bitleitungsabschnitt 14, der Sourceanschluß des Transistors T5 ist mit dem Drainanschluß des Transistors T6 und das Gate des Transistors T5 ist mit dem Bitleitungsabschnitt 15 verbunden. Der Drainanschluß des Transistors T6 ist mit dem SAN-Eingang E2, der Sourceanschluß des Transistors T6 ist mit dem Bitleitungsabschnitt 15 und der Gateanschluß des Transistors T6 ist mit dem Bitleitungsabschnitt 14 verbunden. Zwischen dem Bitleitungspaar BL, BLN und den Bitleitungsabschnitten 14 und 15 liegen die beiden Transfertransistoren 7 und 9, die durch eine Ansteuerleitung 13 ansteuerbar sind. Die Bitleitungsabschnitte 14 und 15 sind durch die beiden weiteren Transfertransistoren 16 und 17 auf die IO-Ausgänge IOA und IONA durchschaltbar. Die Gates der Transistoren 16 und 17 sind mit einem Bitleitungs-Auswahleingang CSLE verbunden. Drei weitere n-Kanal-Transistoren 6, 8 und 10 bilden eine Kurzschluß/Vorlade-Schaltung, wobei der Drainanschluß des Transistors 6 mit einem Eingang 5, der Sourceanschluß mit der Bitleitung BL und der Gateanschluß mit einem Eingang 12, der Drainanschluß des Transistors 8 mit der Bitleitung BL, der Sourceanschluß mit der Bitleitung BLN, der Gateanschluß mit dem Eingang 12, der Drainanschluß des Transistors 10 mit der Bitleitung BLN, der Sourceanschluß mit einem Eingang 11 und der Gateanschluß mit dem Eingang 12 verbunden ist. Der Drainanschluß des Transistors 3 der Speicherzelle Z ist mit der Bitleitung BL, der Sourceanschluß ist über den Zellenkondensator 4 mit Bezugspotential und das Gate ist mit der Wortleitung WL verbunden.

Durch die Kurzschluß/Vorlade-Schaltung mit den Transistoren 6, 8 und 10 werden die Bitleitungen BL und BLN vorübergehend kurzgeschlossen und auf denselben Vorladepegel aufgeladen. Bei leitenden Transfertransistoren 7 und 9 werden alle durch eine Wortleitung WL adressierten Zellen auf die vorgeladenen Bitleitungen ausgelesen. So wird zum Beispiel die in Figur 2 dargestellte Speicherzelle Z auf die Bitleitung BL ausgelesen und durch die kreuzgekoppelten n-Kanal-Transistoren T₅ und T₆ bewertet, wobei eine Differenzspannung zwischen den Bitleitungen BL und BLN verstärkt wird. Die beiden kreuzgekoppelten p-Kanal-Transistoren T3 und T4 unterstützen dabei den weiteren Bewertungsvorgang. Ist der Bewertungsvorgang abgeschlossen so werden die beiden Transfertransistoren 16 und 17 durch ein Bitleitungsauswahlsignal am Bitleitungsauswahleingang CSLE leitend und die Bitleitungen BL und BLN werden auf die IO-Ausgänge IOA und IONA durchgeschaltet. Zur Aktivierung des n-Kanal-Teils SAN muß der SAN-Eingang E2 möglichst schnell auf Bezugspotential gebracht werden. Damit eine möglichst schnelle Aktivierung erfolgt und trotzdem keine Falschbewertung auftritt ist am Eingang E2 eine geeignete Steuerspannung erforderlich. Eine geeignete Steuerspannung mit optimierter Spannungs/Zeit-Funktion kann beispielsweise in einem SAN-Treiber erzeugt werden. Ähnliches gilt in entsprechender Weise für den SAP-Eingang E1.

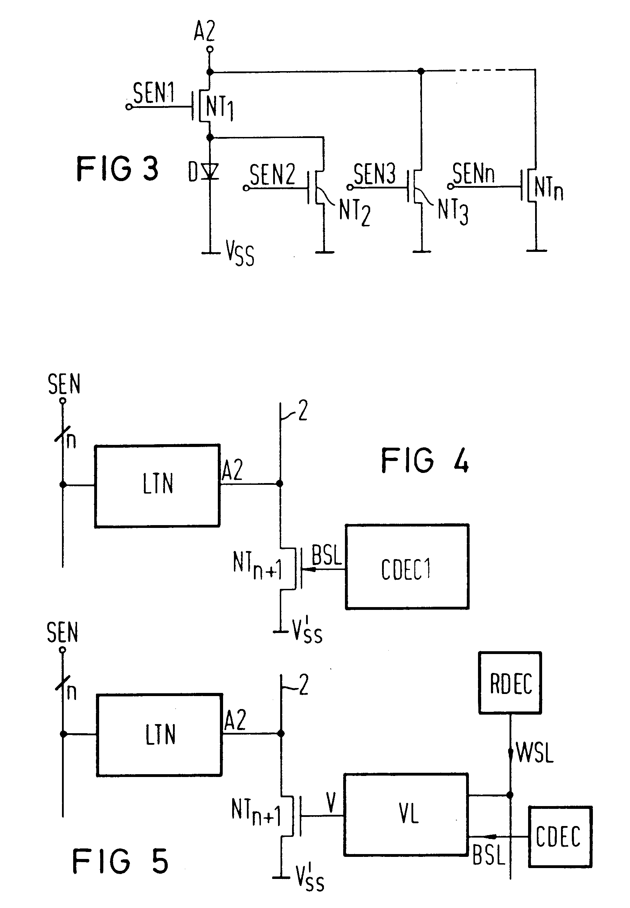

In Figur 3 ist ein möglicher SAN-Treiber dargestellt. Es handelt sich hierbei um einen lokalen n-phasigen SAN-Treiber, der durch n Ansteuerleitungen SEN1 bis SENn ansteuerbar ist. Der Drainanschluß eines Transistors NT₁ ist mit dem Treiberausgang A2, der Sourceanschluß ist über eine Diode D mit einer Bezugspotentialleitung V_{SS} und der Gateanschluß ist mit der zeitlich ersten Phase SEN1 der n Steuerleitungen SEN verbunden. Die Diode D ist dabei in Flußrichtung gepolt und zu ihr parallel geschaltet befindet sich ein Transistor NT₂, dessen Gate mit der Leitung SEN2 verbunden ist. Der Drainanschluß eines Transistors NT₃ ist mit dem Treiberausgang A2, der Sourceanschluß ist mit der Bezugspotentialleitung V_{SS} und der Gateanschluß mit einer dritten Ansteuerleitung SEN3 verbunden. Ähnlich wie NT₃ können weitere Transistoren bis NT ₙ zu dem Transistor NT₃ parallelgeschaltet werden um eine möglichst gute Approximation einer idealen Ansteuerkurve zu erreichen. Das Gate des n-ten Treibertransistors NTₙ ist dabei mit der Ansteuerleitung SENn verbunden. Es ist von untergeordneter Bedeutung ob die Signale der Ansteuerleitungen SEN1 ... SENn außerhalb des lokalen SAN-Treibers bildbar sind, oder ob sie in den lokalen SAN-Treibern jeweils durch Laufzeitschaltungen aus beispielsweise dem Signal der Ansteuerleitung SEN1 bildbar sind.

Bekommt die Steuerleitung SEN1 High-Potential so wird der Transistor NT₁ leitend und die Spannung am Treiberausgang A2 nimmt die Schwellenspannung der Diode D an. Sobald jetzt die zweite Ansteuerleitung SEN2 High-Potential erhält wird der Treibertransistor NT₂ ebenfalls leitend und zwischen dem Treiberausgang A2 und der Bezugspotentialleitung V_{SS} liegen die beiden in Reihe geschalteten Kanalwiderstände der Transistoren NT₁ und NT₂, die infolge des Treiberstromes einen Spannungsabfall an A2 hervorrufen. Durch die nacheinander zusätzlich leitendwerdenden Treibertransistoren NT₃ bis NTₙ werden Kanalwiderstände parallelgeschaltet und führen durch den niedrigeren Gesamtwiderstand zu einer geringeren Spannung zwischen A2 und der Bezugspotentialleitung V_{SS}.

Figur 4 zeigt eine Beschleunigungsschaltung, die nur aus einem Treibertransistor NTₙ₊₁ besteht und Bestandteil eines erfindungsgemäßen dynamischen Halbleiterspeichers ist. Der Treibertransistor NTₙ₊₁ wird an seinem Gateanschluß nur durch ein Bitleitungsblock-Auswahlsignal BSL angesteuert, wenn, wie in diesem Fall, pro Wortleitungsblock WLB eigene Column-Dekoder CDEC1 vorhanden sind. Der Drainanschluß des Treibertransistors NTₙ₊₁ ist mit dem Ausgang A2 eines lokalen SAN-Treibers LTN verbunden und sein Sourceanschluß ist mit einer Bezugspotential-Leitung V′_{SS} kontaktiert. Die Bezugspotential-Leitung V′_{SS} ist vorteilhafterweise getrennt von einer Bezugspotentailleitung V_{SS} für lokale SAN-Treiber aufgebaut, da aufgrund dessen eine gegenseitige Beeinflussung infolge von Spannungsabfällen auf Zuführungsleitungen ausgeschlossen ist. Der lokale SAN-Treiber wird durch n Ansteuerleitungen SEN angesteuert und sein Ausgang A2 ist mit einer lokalen SANN-Leitung 2 verbunden.

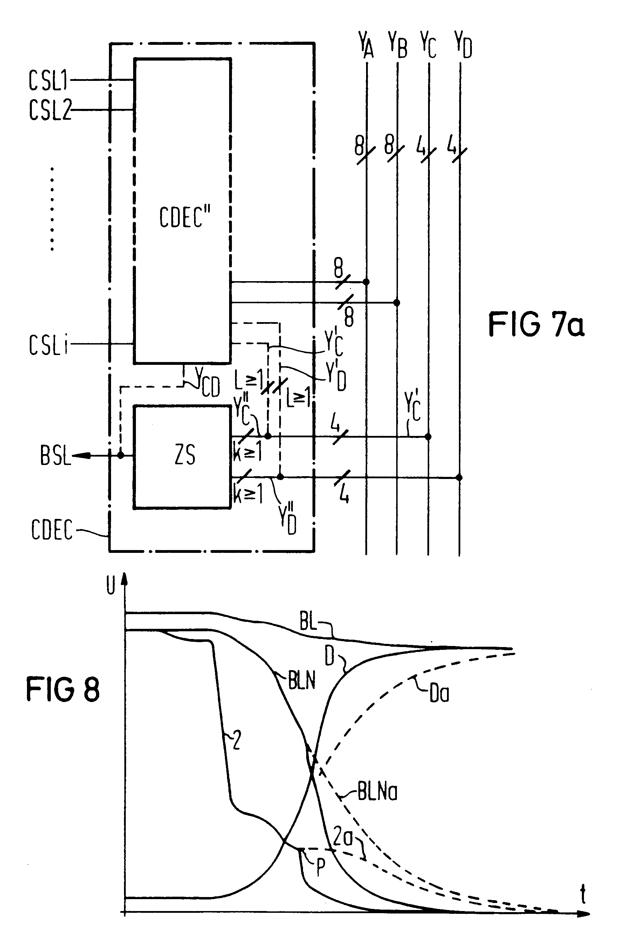

Beim Auslesen eines erfindungsgemäßen dynamischen Halbleiterspeichers werden alle lokalen n-phasigen SAN-Treiber eines Wortleitungsblockes WLB durch n gemeinsame Ansteuerleitungen SEN angesteuert. Die Spannung der lokalen SANN-Leitung 2 sinkt dabei auf einen in Figur 8 mit P bezeichneten Wert ab. Solange alle Treibertransistoren NTₙ₊₁ eines Wortleitungsblocks WLB noch sperrend sind, findet eine Bewertung ohne Beschleunigung statt. Bekommt nun das Bitleitungsblock-Auswahlsignal aus dem Column-Dekoder CDEC1 High-Potential, so wird der Treibertransistor NTₙ₊₁ leitend und die lokale SANN-Leitung wird relativ schnell auf Bezugspotential gebracht. Um die lokale SANN-Leitung 2 relativ schnell auf Bezugspotential zu entladen, ist ein relativ hoher Spitzenstrom auf der lokalen SANN-Leitung erforderlich. Da dieser hohe Spitzenstrom allerdings bei einem erfindungsgemäßen Halbleiterspeicher nur in einem einzigen Bitleitungsblock auftritt, ist der Gesamtspitzenstrom des erfindungsgemäßen dynamischen Halbleiterspeichers durch die Beschleunigungsschaltung nur unwesentlich erhöht.

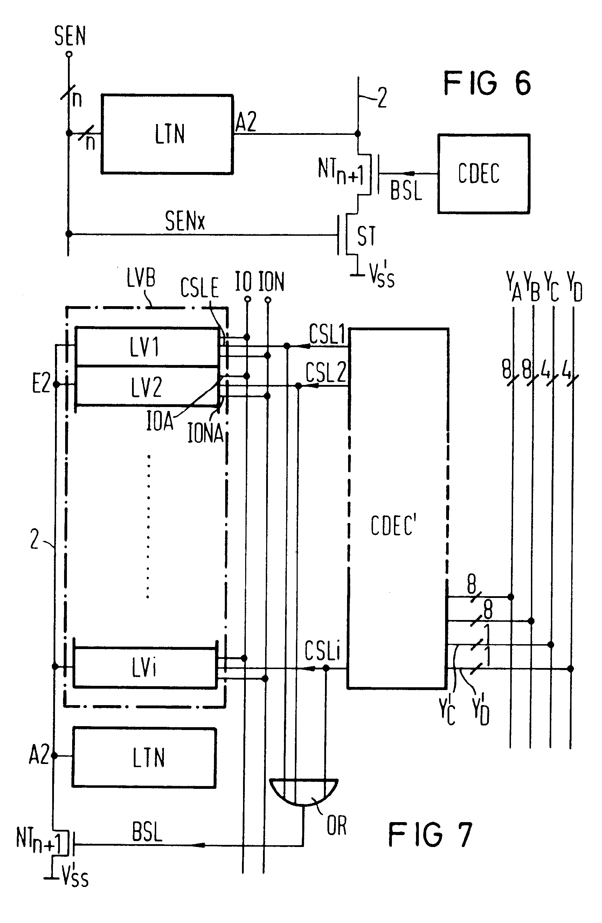

Die in Figur 5 gezeigte Schaltung betrifft einen erfindungsgemäßen dynamischen Halbleiterspeicher, bei dem übergeordnete Column-Dekoder CDEC gleichzeitig für mehrere Wortleitungsblöcke zur Verfügung stehen. Die in Figur 5 gezeigte Schaltung unterscheidet sich von der in Figur 4 gezeigten Schaltung nur in der Ansteuerung des Treibertransistors NTₙ₊₁. Um eindeutig einen Bitleitungsblock auszuwählen, muß das Bitleitungsblock-Auswahlsignal BSL erst in einer Verknüpfungslogik VL mit einem Wortleitungsblock-Auswahlsignal WSL verknüpft werden. Der Ausgang V der Verknüpfungslogik VL ist hierzu mit dem Gate des Treibertransistors NTₙ₊₁ verbunden. Die Bildung des Bitleitungsblock-Auswahlsignals im Column-Dekoder CDEC ist in der Beschreibung zu Figur 7 und 8 näher erläutert. Die Bildung des Wortleitungsblock-Auswahlsignals WSL geschieht in einem Row-Dekoder, bei dem, wie beim Column-Dekoder, meist vorkodierte Adreßleitungen durch logische Verknüpfungen zu einem Wortleitungsblock-Auswahlsignal WSL zusammengefaßt sind. Würde der Treibertransistor NTₙ₊₁ nur durch das Bitleitungsblock-Auswahlsignal BSL angesteuert, so könnte zwar nur der durch das Bitleitungsauswahlsignal BSL im durch die Ansteuerleitungen SEN adressierten Wortleitungsblock WLB bewertet werden, aber die relativ hohen Ströme durch die Treibertransistoren würden somit auch in den anderen Wortleitungsblöcken fließen und sich ungünstig auf den Gesamtspitzenstrom auswirken.

Die in Figur 6 gezeigte Beschleunigungsschaltung eines erfindungsgemäßen dynamischen Halbleiterspeichers besteht aus einem Treibertransistor NTₙ₊₁ und einem Auswahltransistor ST, wobei beide Transistoren so in Reihe geschaltet sind, daß der Drainanschluß des Treibertransistors NTₙ₊₁ mit einer lokalen SANN-Leitung 2 und der Sourceanschluß des Treibertransistors NTₙ₊₁ mit dem Drainanschluß des Auswahltransistors und dessen Sourceanschluß mit der Bezugspotential-Leitung V′_{SS} verbunden ist. Ein lokaler SAN-Treiber wird, wie bei Figur 4 und 5 beschrieben, durch n Ansteuerleitungen SEN angesteuert und sein Ausgang A2 ist mit der lokalen SANN-leitung 2 verbunden. Eine einzelne Ansteuerleitung SENx der n Ansteuerleitungen SEN ist mit dem Gate des Auswahltransistors ST verbunden. Bevorzugterweise wird das Gate des Auswahltransistors ST durch die letzte, n-te Phase der Ansteuerleitung SENn angesteuert. Durch die Ansteuerleitung SENx erfolgt die eindeutige Festlegung eines Wortleitungsblockes, da der Column-Dekoder übergeordnet ist und mehrere Wortleitungsblöcke gleichzeitig ansteuert. Die Auswahl des Bitleitungsblocks erfolgt, wie bei Figur 4, durch ein Bitleitungsblock-Auswahlsignal BSL, das in einem Column-Dekoder CDEC bildbar ist.

Die aus Row-Adressen generierten Signale der n Ansteuerleitungen SEN erhalten nacheinander zeitlich versetzt High-Potential, um nacheinander alle n Phasen des lokalen SAN-Treibers LTN zu erzeugen. Da die n Ansteuerleitungen SEN für jeden Wortleitungsblock getrennt vorhanden sind, kann die Auswahl eines Wortleitungsblocks durch eine der n Ansteuerleitungen SEN erfolgen. Da der Treibertransistor NTₙ₊₁ des ausgewählten Bitleitungsblocks erst zu einem Zeitpunkt n+1, nach dem bereits alle n Stufen eines lokalen SAN-Treibers eingeschaltet sind, durch das Bitleitungsblock-Auswahlsignal BSL leitend wird, genügt die Ansteuerleitung SENx der n-ten Phase (x = n) zur Ansteuerung des Auswahltransistors ST. Durch den zum Treibertransistor NTₙ₊₁ in Reihe geschalteten Auswahltransistor ST wird bewirkt, daß nur der zum ausgewählten Wortleitungsblock gehörige Bitleitungsblock eine beschleunigte Bewertung erfährt und deshalb der Gesamtspitzenstrom nur unwesentlich erhöht wird, obwohl durch den übergeordneten Column-Dekoder CDEC in jedem Wortleitungsblock ein Bitleitungsblock durch das Bitleitungs-Auswahlsignal BSL ausgewählt wird.

Eine Möglichkeit zur Erzeugung eines Blockauswahlsignals BSL bei einem erfindungsgemäßen dynamischen Halbleiterspeicher ist in Figur 7 gezeigt. Bei der in Figur 7 dargestellten Schaltung besteht die Beschleunigungsschaltung nur aus einem Treibertransistor NTₙ₊₁ der, wie bei Figur 4, direkt durch das Bitleitungsblock-Auswahlsignal BSL ansteuerbar ist. Der Treibertransistor kann aber auch, wie bei Figur 5 über eine Verknüpfungslogik VL angesteuert werden oder, wie bei Figur 6, mit einem Auswahltransistor ST in Reihe geschaltet sein. Der Drainanschluß eines Treibertransistors NTₙ₊₁ ist mit dem Ausgang A2 eines lokalen SAN-Treibers LTN und über eine lokale SANN-Leitung 2 mit den Eingängen E2 der Leseverstärker LV1 ... LVi eines Leseverstärkerblocks LVB verbunden. Der Sourceanschluß des Treibertransistors NTₙ₊₁ ist mit einer Bezugspotentialleitung V′_{SS} kontaktiert. Die IO-Ausgänge IOA und IONA der Leseverstärker LV1 ... LVi sind jeweils mit IO-Leitungen IO und ION verbunden. Ein adressierbarer Auswahldekoder CDEC′ erzeugt an seinen Ausgängen Bitleitungs-Auswahlsignale CSL1 ... CSLi, die in die Bitleitungs-Auswahleingänge CSLE von Leseverstärkern LV1 ... LVi einspeisbar sind. Im Auswahldekoder CDEC′ erfolgt eine (1 aus 1)-Auswahl, das heißt, daß jeweils nur ein Bitleitungs-Auswahlsignal, beispielsweise CSL1, auf High-Potential geschaltet wird und die restlichen Bitleitungs-Auswahlsignale Low-Potential führen. Da alle durch die Bitleitungs-Auswahlsignale CSL1 ... CSLi ausgewählten Bitleitungen zum selben Bitleitungsblock LVB gehören, sind alle Bitleitungs-Auswahlsignale CSL1 ... CSLi zu einem Bitleitungsblock-Auswahlsignal BSL durch eine ODER-Schaltung OR verknüpft. Auswahleingänge des adressierbaren Column-Dekoders CDEC′ sind mit vorkodierten, zum Beispiel (1 aus 8)-vorkodierten, Column-Adressen Y_{A} und Y_{B} und die Adreßeingänge des adressierbaren Column-Dekoders CDEC′ sind mit einem Teil Y′_{C} und Y′_{C} der vorkodierten, zum Beispiel (1 aus 4)-vorkodierten, Column-Adressen Y_{C} und Y_{D} verbunden.

Für den Fall das die Column-Adressen Y_{A} und A_{B} (1 aus 8)- und die Column-Adressen Y_{C} und Y_{C} jeweils (1 aus 4)-vorkodiert sind, kann ein adressierbarer Column-Dekoder CDEC′ i = 8*8 = 64 Leseverstärker pro Leseverstärkerblock LVB ansteuern und können 4*4 = 16 dieser adressierbaren Auswahldekoder CDEC′ adressiert werden. Zur Adressierung des Column-Dekoders CDEC′ sind im einfachsten Fall, bei positiver Logik, jeweils nur eine Adreßleitung Y′_{C} und Y′_{D} erforderlich. Besteht ein Leseverstärkerblock LVB aus zum Beispiel 64 Leseverstärkern, so kann durch ein 1 aus 64 kodiertes Bitleitungs-Auswahlsignal genau ein Bitleitungspaar auf ein Paar von IO-Leitungen IO und ION durchgeschaltet werden. In vielen Fällen sind mehrere Paare von IO-Leitungen IO und ION vorhanden und es können so gleichzeitig mehrere Bitleitungspaare parallel ausgelesen werden, was jedoch keinen unmittelbaren Einfluß auf die Bildung des Bitleitungsauswahlsignals zur Folge hat. Sind beispielsweise zwei Paare von IO-Leitungen IO und ION vorhanden, so ist lediglich ein Auswahldekoder mit einer (2 aus i)-Kodierung und zum Beispiel nur 4 anstatt 8 vorkodierte Column-Adreßleitungen Y_{B} erforderlich.

Die Verknüpfung der Bitleitungs-Auswahlsignale durch eine ODER-Schaltung OR ist relativ aufwendig und stellt eher eine prinzipielle Möglichkeit dar. In Figur 7a sind deshalb weitere Möglichkeiten zur Erzeugung eines Bitleitungsblock-Auswahlsignales BSL innerhalb eines Column-Dekoders CDEC dargestellt. Wie bei Figur 7 sind Adreßleitungen Y_{A} und Y_{B} für kodierte, zum Beispiel (1 aus 8)-vorkodierte, Column-Adressen mit einem adressierbaren Auswahldekoder CDEC˝ verbunden. Adreßleitungen Y′_{C} und Y′_{D} der Adreßleitungen Y_{C} und Y_{D} werden wie bei Figur 7 zur Adressierung des adressierbaren Auswahldekoders CDEC˝ verwendet und darüber hinaus werden Adreßleitungen Y˝_{C} und Y˝_{D} der Adreßleitungen Y_{C} und Y_{D} zur parallelen Bildung des Bitleitungsblock-Auswahlsignals in einer Zusatzschaltung ZS genutzt, wobei die Adreßleitungen Y′_{C}, Y′_{D} mit den Adreßleitungen Y˝_{C}, Y˝_{D} identisch sein können. Ist aus Zeitgründen keine parallele Bildung des Bitleitungsblocks-Auswahlsignales BSL erforderlich, so kann das Bitleitungsblock-Auswahlsignal BSL zur Adressierung eines dadurch einfacher aufbaubaren Auswahldekoders verwendet werden, wobei hierzu das Bitleitungsblock-Auswahlsignal BSL einem einzelnen Adressierungseingang Y_{CD} des adressierbaren Auswahldekoders CDEC˝ zugeführt wird. Im einfachsten Fall, bei positiver Logik, wird nur eine Column-Adresse Y˝_{C} der beispielsweise vier Leitungen für die (1 aus 4)-vorkodierte Column-Adresse Y_{C} und eine Leitung für die Adresse Y˝_{D} der zum Beispiel vier Leitungen der Column-Adresse Y_{D} durch eine Zusatzschaltung in Form einer UND-Schaltung zu einem Bitleitungsblock-Auswahlsignal BSL verknüpft. Im Falle einer komplizierteren Vorkodierung der Column-Adressen Y_{C} und Y_{D}, zum Beispiel bei negativer Logik können 1 größer gleich eins Leitungen, beispielsweise drei Leitungen, zur direkten Adressierung des adressierbaren Auswahldekoders CDEC˝ und k größer gleich eins Leitungen für die Zusatzschaltung ZS benötigt werden.

Das in Figur 8 gezeigte Spannungszeitdiagramm läßt die Verbesserung der Bewertungszeit aufgrund der Beschleunigungsschaltung eines erfindungsgemäßen dynamischen Halbleiterspeichers erkennen, wobei die Parameterbezeichnung einer Kurve dem jeweiligen Index der Spannung U entspricht. Die dort gezeigten Spannungsverläufe ergeben sich bei nicht aktivierten p-Kanal-Teilen der Leseverstärker. Die Spannung U₂ stellt die Spannung der lokalen SANN-Leitung dar, dabei setzt ab dem Punkt P die Beschleunigungsschaltung ein und läßt die Spannung U₂ schneller gegen Bezugspotential gehen als dies ohne Beschleunigungsschaltung der Fall ist und durch die Spannung U₂ₐ gestrichelt angedeutet ist. Sofern eine mit der Bitleitung BL verbundene Speicherzelle eine logische l gespeichert hat wird die Spannung U_{BL} beim Auslesen dieser Speicherzelle nur unwesentlich absinken, die Spannung U_{BLN} wird hingegen stark gegen Bezugspotential absinken, was ein starkes Ansteigen der Differenzspannung U_{D} zur Folge hat. Die gestrichelt angedeuteten Spannungsverläufe U_{BLNa} der Vergleichsbitleitung und die daraus resultierende ebenfalls gestrichelt angedeutete Differenzspannung U_{Da} zeigen vergleichsweise die Verläufe ohne Beschleunigungsschaltung.

## Patentansprüche

1. Dynamischer Halbleiterspeicher
- mit einer Speicherzellenanordnung, die aus mindestens einem Wortleitungsblock (WLB) besteht und mindestens ein Wortleitungsblock aus einer Vielzahl von Bitleitungsblöcken (TB, TB′ ...) aufgebaut ist, wobei jeweils ein Bitleitungsblock eine Vielzahl von Bitleitungspaaren (BL, BLN) umfaßt,
- mit einer Vielzahl von Leseverstärkerblöcken (LVB, LVB′, LVB˝, ...), die jeweils aus einer Vielzahl von Leseverstärkern (LV) besteht, wobei jeweils ein Leseverstärker mit einem Bitleitungspaar eines dem jeweiligen Leseverstärkerblock zugeordneten Bitleitungsblocks verbunden und aus einem n-Kanal-Teil (SAN) und einem p-Kanal-Teil (SAP) aufgebaut ist,
- mit Leseverstärkern, deren verstärkte Lesesignale, abhängig von Bitleitungs-Auswahlsignalen (CSL1 ... CSLi), auf IO-Leitungen (IO, ION) durchschaltbar sind, wobei die Bitleitungs-Auswahlsignale durch einen Column-Dekoder erzeugbar sind,
- mit einer Vielzahl von lokalen SAN-Treibern, von denen jeweils einer zur gemeinsamen Ansteuerung der n-Kanal-Teile (SAN) der Leseverstärker eines jeweiligen Leseverstärkerblocks vorgesehen ist,
- mit lokalen SAN-Treibern, die jeweils, zur Erzielung einer beschleunigten Bewertung bei geringem Spitzenstrom, zusätzlich eine Beschleunigungsschaltung mit einem Treibertransistor (NTₙ₊₁) aufweisen und die jeweils mit einem Anschluß des Treibertransistors (NTₙ₊₁) verbunden sind und
- mit Beschleunigungsschaltungen, die so ansteuerbar sind, daß die beschleunigte Bewertung nur bei dem Leseverstärkerblock erfolgt, bei dem auch die verstärkten Lesesignale, abhängig von den Bitleitungsauswahlsignalen (CSL1 ... CSLi), auf die IO-Leitungen (IO, ION) durchgeschaltet werden.

2. Dynamischer Halbleiterspeicher nach Anspruch 1, **dadurch gekennzeichnet**, daß die Beschleunigungsschaltung nur aus dem Treibertransistor (NTₙ₊₁) besteht, daß ein zweiter Anschluß des Treibertransistors (NTₙ₊₁) direkt durch ein Bitleitungsblock-Auswahlsignal (BSL) ansteuerbar ist, sofern für einzelne Wortleitungsblöcke eigene Column-Dekoder (CDEC1) vorgesehen sind, und daß der dritte Anschluß des Treibertransistors (NTₙ₊₁) direkt mit einer Bezugspotential-Leitung (V′_{SS}) verbunden ist.

3. Dynamischer Halbleiterspeicher nach Anspruch 1, **dadurch gekennzeichnet**, daß die Beschleunigungsschaltung nur aus dem Treibertransistor (NTₙ₊₁) besteht, daß ein zweiter Anschluß des Treibertransistors (NTₙ₊₁), zur Ansteuerung mit dem Ausgang (V) einer Verknüpfungslogik (VL) verbunden ist und durch die Verknüpfungslogik (VL) ein Bitleitungsblock-Auswahlsignal (BSL) mit einem Wortleitungsblock-Auswahlsignal (WSL) verknüpft ist, sofern für mehrere Wortleitungsblöcke gemeinsam ein übergeordneter Column-Dekoder (CDEC) vorgesehen ist und daß der dritte Anschluß des Treibertransistors direkt mit einer Bezugspotential-Leitung (V′_{SS}) verbunden ist.

4. Dynamischer Halbleiterspeicher nach Anspruch 3, **dadurch gekennzeichnet**, daß die Verknüpfungslogik (VL) aus einer UND-Verknüpfung besteht.

5. Dynamischer Halbleiterspeicher nach Anspruch 1, **dadurch gekennzeichnet**, daß die Beschleunigungsschaltung den Treibertransistor (NTₙ₊₁) und einen Auswahltransistor (ST) besitzt, daß ein zweiter Anschluß des Treibertransistors (NTₙ₊₁) direkt durch ein Bitleitungsblock-Auswahlsignal (BSL) ansteuerbar ist, daß der dritte Anschluß des Treibertransistors (NTₙ₊₁) mit einem ersten Anschluß des Auswahltransistors (ST) verbunden ist, daß, um eine Wortleitungsblock-Auswahl zu bewirken, ein zweiter Anschluß des Auswahltransistors (ST) über eine Ansteuerleitung (SENx) eines lokalen SAN-Treibers ansteuerbar ist und daß der dritte Anschluß des Auswahltransistors (ST) mit einer Bezugspotential-Leitung (V′_{SS}) verbunden ist.

6. Dynamischer Halbleiterspeicher nach Anspruch 5, **dadurch gekennzeichnet**, daß im Falle eines n-phasigen SAN-Treibers mit n Ansteuerleitungen (SEN1 ... SENn), der zweite Anschluß des Auswahltransistors (ST) über die Ansteuerleitung (SENn) der zeitlich letzten, n-ten Phase ansteuerbar ist.

7. Dynamischer Halbleiterspeicher nach Anspruch 1, **dadurch gekennzeichnet**, daß der Column-Dekoder (CDEC) einen adressierbaren Auswahl-Dekoder (CDEC′, CDEC˝) zur Erzeugung der Bitleitungs-Auswahlsignale (CSL1 ... CSLi) und eine Zusatzschaltung (ZS) zur Erzeugung eines Bitleitungsblock-Auswahlsignales (BSL) besitzt und daß Column-Adreßleitungen (Y_{A}, Y_{B}), zur Bildung der Bitleitungs-Auswahlsignale (CSL1 ... CSLi), mit dem Auswahldekoder (CDEC′, CDEC˝) verbunden sind.

8. Dynamischer Halbleiterspeicher nach Anspruch 7, **dadurch gekennzeichnet**, daß jeweils alle Bitleitungs-Auswahlsignale (CSL1 ... CSLi) des Auswahl-Dekoders (CDEC′), durch eine Zusatzschaltung in Form einer ODER-Schaltung (OR) zu einem Bitleitungsblock-Auswahlsignal (BSL) verknüpft sind.

9. Dynamischer Halbleiterspeicher nach Anspruch 7, **dadurch gekennzeichnet**, daß der Auswahl-Dekoder (CDEC˝) einen Eingang (Y_{CD}) zur Adressierung (Aktivierung) besitzt, daß ein das Bitleitungsblock-Auswahlsignal (BSL) führender Ausgang der Zusatzschaltung (ZS) mit einem Eingang (Y_{CD}) zur Adressierung (Aktivierung) des Auswahl-Dekoders (CDEC˝) verbunden ist und daß Eingänge (Y˝_{C}, Y˝_{D}) der Zusatzschaltung (ZS) mit weiteren Column-Adreßleitungen (Y_{C}, Y_{D}) verbunden sind.

10. Dynamischer Halbleiterspeicher nach Anspruch 7, **dadurch gekennzeichnet**, daß der Auswahl-Dekoder (CDEC˝) Eingänge (Y′_{C}, Y′_{D}) zur Adressierung (Aktivierung) besitzt und diese Eingänge (Y′_{C}, Y′_{D}) mit weiteren Column-Adreßleitungen (Y_{C}, Y_{D}) verbunden sind und daß Eingänge (Y˝_{C}, Y˝_{D}) der Zusatzschaltung (ZS) mit weiteren Column-Adreßleitungen (Y_{C}, Y_{D}) verbunden sind.

11. Dynamischer Halbleiterspeicher nach Anspruch 9 oder 10, **dadurch gekennzeichnet**, daß die Zusatzschaltung (ZS) aus einer UND-Verknüpfung besteht.

12. Dynamischer Halbleiterspeicher nach Anspruch 1, **dadurch gekennzeichnet**, daß die Beschleunigungsschaltung mit einer ersten Bezugspotential-Leitung (V′_{SS}) verbunden ist und daß der lokale SAN-Treiber mit einer zur ersten Bezugspotential-Leitung getrennt geführten, zweiten Bezugspotential-Leitung (V_{SS}) verbunden ist.

## Claims

1. A dynamic semiconductor memory
- having a memory cell arrangement which comprises at least one word line block (WLB), and at least one word line block (WLB) is composed of a multiplicity of bit line blocks (TB, TB′ ...), one bit line block in each case comprising a multiplicity of bit line pairs (BL, BLN),
- having a multiplicity of read amplifier blocks (LVB, LVB′, LVB˝, ...) which in each case comprise a multiplicity of read amplifiers (LV), in each case one read amplifier being connected to a bit line pair of a bit line block which is allocated to the respective read amplifier block and being constructed from an n-channel part (SAN) and a p-channel part (SAP),
- having read amplifiers whose amplified read signals can be switched through to IO lines (IO, ION) as a function of bit-line selection signals (CSL1 ... CSLi), it being possible to produce the bit-line selection signals by means of a column decoder,
- having a multiplicity of local SAN drivers of which in each case one is provided for the common drive of the n-channel parts (SAN) of the read amplifiers of a respective read amplifier block,
- having local SAN drivers which, in order to achieve accelerated evaluation with a low peak current, in each case additionally have an acceleration circuit with a driver transistor (NTₙ₊₁) and are in each case connected to a terminal of the driver transistor (NTₙ₊₁), and
- having acceleration circuits which can be driven such that the accelerated evaluation takes place only in that read amplifier block in which the amplified read signals are also switched through to the IO lines (IO, ION) as a function of the bit-line selection signals (CSL1 ... CSLi).

2. Dynamic semiconductor memory according to Claim 1, characterised in that the accelerator circuit comprises only the driver transistor (NTₙ₊₁), in that a second terminal of the driver transistor (NTₙ₊₁) can be directly driven by a bit line block selection signal (BSL), provided that separate column decoders (CDEC1) are provided for individual word line blocks, and in that the third terminal of the driver transistor (NTₙ₊₁) is directly connected to a reference potential line (V′_{SS}).

3. Dynamic semiconductor memory according to Claim 1, characterised in that the accelerator circuit consists only of the driver transistor (NTₙ₊₁), in that, for driving, a second terminal of the driver transistor (NTₙ₊₁) is connected to the output (V) of a logic circuit (VL) and, by means of the logic circuit (VL), a bit line block selection signal (BSL) is gated with a word line block selection signal (WSL), inasmuch as a common, superordinate column decoder (CDEC) is provided for a plurality of word line blocks, and in that the third terminal of the driver transistor is directly connected to a reference potential line (V′_{SS}).

4. Dynamic semiconductor memory according to Claim 3, characterised in that the logic circuit (VL) comprises an AND gate.

5. Dynamic semiconductor memory according to Claim 1, characterised in that the accelerator circuit includes the driver transistor (NTₙ₊₁) and a selection transistor (ST), in that a second terminal of the driver transistor (NTₙ₊₁) can be directly driven by a bit line block selection signal (BSL), in that the third terminal of the driver transistor (NTₙ₊₁) is connected to a first terminal of the selection transistor (ST), in that, in order to select a word line block, a second terminal of the selection transistor (ST) can be driven via a drive line (SENx) of a local SAN driver, and in that the third terminal of the selection transistor (ST) is connected to a reference potential line (V′_{SS}).

6. Dynamic semiconductor memory according to Claim 5, characterised in that, given an n-phase SAN driver with n drive lines (SEN1 ... SENn), the second terminal of the selection transistor (ST) can be driven via the drive line (SENn) of the temporally last, nth phase.

7. Dynamic semiconductor memory according to Claim 1, characterised in that the column decoder (CDEC) includes an addressable selection decoder (CDEC′, CDEC˝) for generating the bit line selection signals (CSL1 ... CSLi) and a supplementary circuit (ZS) for generating is bit line block selection signal (BSL), and in that column address lines (Y_{A}, Y_{B}) are connected to the selection decoder (CDEC′, CDEC˝) for forming the bit line selection signals (CSL1 ... CSLi).

8. Dynamic semiconductor memory according to Claim 7, characterised in that in each case all bit line selection signals (CSL1 ... CSLi) of the selection decoder (CDEC′) are gated by means of a supplementary circuit in the form of an OR circuit (OR) to form a bit line block selection signal (BSL).

9. Dynamic semiconductor memory according to Claim 7, characterised in that the selection decoder (CDEC˝) includes an input (Y_{CD}) for addressing (activation), in that an output of the supplementary circuit (ZS) carrying the bit line block selection signal (BSL) is connected to an input (Y_{CD}) for addressing (activating) the selection decoder (CDEC˝), and in that inputs (Y˝_{C}, Y˝_{D}) of the supplementary circuit (ZS) are connected to further column address lines (Y_{C}, Y_{D}).

10. Dynamic semiconductor memory according to Claim 7, characterised in that the selection decoder (CDEC˝) includes inputs (Y′_{C}, Y′_{D}) for addressing (activation), and these inputs (Y′_{C}, Y′_{D}) are connected to further column address lines (Y_{C}, Y_{D}), and in that inputs (Y˝_{C}, Y˝_{D}) of the supplementary circuit (ZS) are connected to further column address lines (Y_{C}, Y_{D}).

11. Dynamic semiconductor memory according to Claim 9 or 10, characterised in that the supplementary circuit (ZS) consists of an AND gate.

12. Dynamic semiconductor memory according to Claim 1, characterised in that the accelerator circuit is connected to a first reference potential line (V′_{SS}), and in that the local SAN driver is connected to a second reference potential line (V_{SS}) which is separate from the first reference potential line.

## Revendications

1. Mémoire dynamique à semiconducteurs comportant
- un dispositif de cellules de mémoire, qui est constitué par au moins un bloc de lignes de transmission de mots (WLB), au moins un bloc de lignes de transmission de mots étant constitué par une multiplicité de blocs de lignes de transmission de bits (TB, TB′, ...), tandis que respectivement un bloc de lignes de transmission de bits comprend une multiplicité de couples de lignes de transmission de bits (BL, BLN),
- une multiplicité de blocs d'amplificateurs de lecture (LVB, LVB′, LVB˝, ...), qui sont constitués chacun par une multiplicité d'amplificateurs de lecture (LV), respectivement un amplificateur de lecture étant relié à un couple de lignes de transmission de bits d'un bloc de lignes de transmission de bits associé au bloc respectif d'amplificateurs de lecture et étant constitué par une partie à canal n (SAN) et une partie à canal p (SAP),
- des amplificateurs de lecture, dont les signaux de lecture amplifiés peuvent être transmis dans des lignes d'entrée/sortie (IO, ION), en fonction de signaux (CSL1 ... CLSi) de sélection des lignes de transmission de bits, et de signaux de sélection de lignes de transmission bits pouvant être produites par un décodeur de colonnes,
- une multiplicité d'étages d'attaque SAN locaux, dont l'un respectivement est prévu pour la commande commune des parties à canal n (SAN) des amplificateurs de lecture d'un bloc respectif d'amplificateurs de lecture,
- des étages d'attaque SAN locaux, qui possèdent en outre chacun, pour l'obtention d'une évaluation accélérée dans le cas d'un faible courant maximum, un circuit d'accélération comportant un transistor d'attaque (NTₙ₊₁), et qui sont reliés chacun à une borne du transistor d'attaque (NTₙ₊₁), et des circuits d'accélération, qui peuvent être commandés de manière que l'évaluation accélérée s'effectue uniquement pour le bloc d'amplificateurs de lecture, dans lequel également les signaux de lecture amplifiés sont transmis directement dans les lignes IO (IO, ION), en fonction des signaux (CSL1...CSLi) de sélection des lignes de transmission de bits.

2. Mémoire dynamique à semiconducteurs suivant la revendication 1, caractérisée par le fait que le circuit d'accélération est constitué uniquement par le transistor d'attaque (NTₙ₊₁), qu'une seconde borne du transistor d'attaque (NTₙ₊₁) peut être commandée directement par un signal (BSL) de sélection de blocs de lignes de transmission de bits, dans la mesure où pour différents blocs de lignes de transmission de mots sont prévus des décodeurs particuliers de colonnes (CDEC1), et que la troisième borne du transducteur d'attaque (NTₙ₊₁) est raccordée directement à une ligne (V′_{SS}) appliquant le potentiel de référence.

3. Mémoire dynamique à semiconducteurs suivant la revendication 1, caractérisé par le fait que le circuit d'accélération est constitué uniquement par le transistor d'attaque (NTₙ₊₁), qu'une seconde borne du transistor d'attaque (NTₙ₊₁) est reliée à un circuit logique combinatoire (VL), pour la commande avec le signal de sortie (V) et qu'un signal (BSL) de bloc de lignes de transmission de bits est combiné, au moyen du circuit logique combinatoire (VL), à un signal (WSL) de sélection de blocs de lignes de transmission de mots, dans la mesure où un décodeur de colonnes de rang supérieur (CDEC) est prévu pour plusieurs blocs de lignes de transmission de mots, et que la troisième borne du transistor d'attaque est reliée directement à une ligne (V′_{SS}) appliquant le potentiel de référence.

4. Mémoire dynamique à semiconducteurs suivant la revendication 3, caractérisée par le fait que le circuit logique combinatoire (VL) est constitué par un circuit combinatoire ET.

5. Mémoire dynamique à semiconducteurs suivant la revendication 1, caractérisée par le fait que le circuit d'accélération possède le transistor d'attaque (NTₙ₊₁) et un transistor de sélection (ST), qu'une seconde borne du transistor d'attaque (NTₙ₊₁) peut être commandée directement par un signal (BSL) de sélection de blocs de lignes de transmission de bits, que la troisième borne du transistor d'attaque (NTₙ₊₁) est reliée à une première borne du transistor de sélection (ST), que pour réaliser une sélection de blocs de lignes de transmission de mots, une seconde borne du transistor de sélection (ST) peut être raccordée par l'intermédiaire d'une ligne de commande (SENx) d'un étage d'attaque SAN local, et que la troisième borne du transistor de sélection (ST) est reliée à une ligne (V′_{SS}) appliquant le potentiel de référence.

6. Mémoire dynamique à semiconducteurs suivant la revendication 5, caractérisée par le fait que dans le cas d'un étage d'attaque SAN à n phases et comportant n lignes de commande (SEN1...SENn), la seconde borne du transistor de sélection (ST) peut être commandée par l'intermédiaire de la ligne de commande (SENn), de la dernière phase dans le temps, à savoir la n-ème phase.

7. Mémoire dynamique à semiconducteurs suivant la revendication 1, caractérisée par le fait que le décodeur de colonne (CDEC) possède un décodeur de sélection adressable (CDEC′, CDEC˝) servant à produire les signaux (CSL1...CSLi) de sélection de lignes de transmission de bits et un circuit supplémentaire (ZS) servant à produire un signal (BSL) de sélection de blocs de lignes de transmission de bits, et que des lignes de transmission d'adresses de colonnes (Y_{A}, Y_{B}) sont reliées au décodeur de sélection (CDEC′, CDEC˝), pour la formation des signaux (CSL1...CSLi) de sélection des lignes de transmission de bits.

8. Mémoire dynamique à semiconducteurs suivant la revendication 7, caractérisée par le fait que respectivement tous les signaux (CSL1...CSLi) de sélection des lignes de transmission de bits du décodeur de sélection (CDEC′) sont combinés au moyen d'un circuit supplémentaire réalisé sous la forme d'un circuit OU (OR) pour former un signal (BSL) de sélection de blocs de lignes de transmission de bits.

9. Mémoire dynamique à semiconducteurs suivant la revendication 7, caractérisée par le fait que le décodeur de sélection (CDEC˝) posséde une entrée (Y_{C2}) pour l'adressage (activation), qu'une sortie, qui transmet le signal (BSL) de sélection de blocs de lignes de transmission de bits, du circuit supplémentaire (ZS) est reliée à une entrée (Y_{CD}) servant à réaliser l'adressage (l'activation) du décodeur de sélection (CDEC˝), et que des entrées (Y˝_{C}, Y˝_{D}) du circuit supplémentaire (ZS) sont reliées à d'autres lignes de transmission d'adresses de colonnes (Y_{C}, Y_{D}).

10. Mémoire dynamique à semiconducteurs suivant la revendication 7, caractérisée par le fait que le décodeur de sélection (CDEC˝) possède des entrées (Y′_{C}, Y′_{D}) pour l'adressage (activation) et que ces entrées (Y′_{C}, Y′_{D}) sont connectées à d'autres lignes de transmission d'adresses de colonnes (Y_{C}, Y_{D}), et que des entrées (Y˝_{C}, Y˝_{D}) du circuit supplémentaire (ZS) sont raccordées à d'autres lignes (Y_{C}, Y_{D}) de transmission d'adresses de colonnes.

11. Mémoire dynamique à semiconducteurs suivant la revendication 9 ou 10, caractérisée par le fait que le circuit supplémentaire (ZS) est constitué par un circuit combinatoire ET.

12. Mémoire dynamique à semiconducteurs suivant la revendication 1, caractérisée par le fait que le circuit d'accélération est relié à une première ligne (V′_{SS}) d'application du potentiel de référence, et que l'étage d'attaque SAN local est connecté à une seconde ligne (V_{SS}) d'application du potentiel de référence, qui s'étend séparément de la première ligne d'application du potentiel de référence.
